# EUROPEAN PATENT APPLICATION

(11) **EP 4 518 167 A1**
(43) Date of publication of application: **05.03.2025**
(21) Application number: 24196567.2
(22) Date of filing: 27.08.2024
(51) Int. Cl.: H04B 1/00, H04B 1/12, H04B 15/04

(54) **RF CIRCUIT INCLUDING SWITCH FOR ISOLATION AND WIRELESS COMMUNICATION DEVICE INCLUDING SAME**

(30) Priority: 31.08.2023 KR 20230115737; 31.10.2023 KR 20230148014
(71) Applicant: Samsung Electronics Co., Ltd, Suwon-si, Gyeonggi-do 16677 (KR)
(72) Inventor: KIM, Heesoo, 16677 Suwon-si, Gyeonggi-do (KR); LEE, Sangyun, 16677 Suwon-si, Gyeonggi-do (KR); BAE, Jeongyeol, 16677 Suwon-si, Gyeonggi-do (KR); LEE, Jiyoung, 16677 Suwon-si, Gyeonggi-do (KR); YOO, Sangmin, 16677 Suwon-si, Gyeonggi-do (KR); LEE, Jongsoo, 16677 Suwon-si, Gyeonggi-do (KR)
(74) Representative: Kuhnen & Wacker Patent- und Rechtsanwaltsbüro PartG mbB

(57) **Abstract**

An RF circuit (100) including: first and second ports (P1, P2) receiving first and second RF signals (RF1, RF2); a (1-1)-th amplification stage (110) and a (1-2)-th amplification stage (120) connected to the first port (P1) and a first ground (GND1) to amplify the first RF signal (RF1); a (2-1)-th amplification stage (130) and a (2-2)-th amplification stage (140) connected to the second port (P2) and a second ground (GND2) to amplify the second RF signal (RF2); a (1-1)-th switch (SW1-1) connected to the (1-1)-th amplification stage (110) and the second ground (GND2), and a (1-2)-th switch (SW1-2) connected to the (1-2)-th amplification stage (120) and the second ground; (GND2) a (2-1)-th switch (SW2-1) connected to the (2-1)-th amplification stage (130) and the first ground (GND1), and a (2-2)-th switch (SW2-2) connected to the (2-2)-th amplification stage (140) and the first ground (GND1); and a mixer (150) to mix the first RF signal (RF1) or the second RF signal (RF2) with an LO signal, and mix the first RF signal (RF1) or the second RF signal (RF2) with the LO signal.

## Description

### Technical Field

Embodiments of the present disclosure described herein relate to a radio frequency (RF) circuit including a switch for isolation and a wireless communication device including the same.

### Discussion of Related Art

A radio frequency integrated circuit (RFIC) may be configured to transmit and receive signals across various bands, and may have input ports that are optimized for each band. For a single receiver including an RFIC to accurately receive and process signals input simultaneously through a plurality of input ports, it may be necessary to isolate undesirable signals coming through the input ports (e.g., unused input ports) not associated with a target band.

In particular, the presence of parasitic inductance in a semiconductor package can introduce unwanted signal components reflected due to this parasitic inductance. When this occurs, the impedance of the parasitic inductance increases in signals in the higher frequency bands, resulting in larger reflected components. This can complicate the isolation of the unwanted signals.

### SUMMARY

Embodiments of the present disclosure provide a radio frequency (RF) circuit including a switch for isolation and a wireless communication device including the same.

According to an embodiment of the present disclosure, there is provided an RF circuit including: a first port configured to receive a first RF signal and a second port configured to receive a second RF signal; a (1-1)-th amplification stage and a (1-2)-th amplification stage connected to the first port and a first ground, wherein the (1-1)-th amplification stage and the (1-2)-th amplification stage are configured to amplify the first RF signal; a (2-1)-th amplification stage and a (2-2)-th amplification stage connected to the second port and a second ground, wherein the (2-1)-th amplification stage and the (2-2)-th amplification stage are configured to amplify the second RF signal; a (1-1)-th switch having a first terminal connected to the (1-1)-th amplification stage and a second terminal connected to the second ground, and a (1-2)-th switch having a first terminal connected to the (1-2)-th amplification stage and a second terminal connected to the second ground; a (2-1)-th switch having a first terminal connected to the (2-1)-th amplification stage and a second terminal connected to the first ground, and a (2-2)-th switch having a first terminal connected to the (2-2)-th amplification stage and a second terminal connected to the first ground; and a mixer stage connected to the (1-1)-th amplification stage and the (1-2)-th amplification stage and configured to mix the first RF signal or the second RF signal with a local oscillator (LO) signal, and connected to the (2-1)-th amplification stage and the (2-2)-th amplification stage and configured to mix the first RF signal or the second RF signal with the LO signal.

According to an embodiment of the present disclosure, there is provided a communication device including: an antenna configured to transmit an RF transmission signal or receive an RF reception signal; a duplexer configured to separate the RF transmission signal and the RF reception signal; and an RF circuit configured to mix one of a first RF signal to a N-th RF signal included in the RF reception signal with an LO signal and offset remaining RF signals of the first RF signal to the N-th RF signal that were not mixed, wherein the RF circuit includes: a plurality of ports configured to receive the first RF signal to the N-th RF signal; a plurality of amplification stages connected to the plurality of ports and a first ground to a N-th ground to amplify the first RF signal to the N-th RF signal; a plurality of switches, each having a first terminal connected to one of the plurality of amplification stages, and a second terminal connected to one of the first ground to the N-th ground; and a mixer stage connected to the plurality of amplification stages to mix the one RF signal with the LO signal and offset the remaining RF signals.

According to an embodiment of the present disclosure, there is provided an RF circuit including: a plurality of ports configured to receive a first RF signal to a N-th RF signal; a plurality of amplification stages connected to the plurality of ports and a first ground to a N-th ground to amplify the first RF signal to the N-th RF signal; a plurality of switches, each having one terminal connected to one of the plurality of amplification stages, and an opposite terminal connected to one of the first ground to the N-th ground; and a mixer stage connected to the plurality of amplification stages to mix one of the first RF signal to the N-th RF signal with a local oscillator (LO) signal and offset remaining RF signals of the first RF signal to the N-th RF signal that were not mixed.

### BRIEF DESCRIPTION OF THE DRAWINGS

The above and other features of the present disclosure will become apparent by describing in detail embodiments thereof with reference to the accompanying drawings.
FIG. 1 illustrates a radio frequency (RF) circuit according to an embodiment of the present disclosure;
FIG. 2 illustrates the operation of an RF circuit when a second RF signal is an aggressor signal, according to some embodiments of the present disclosure;
FIG. 3 illustrates an example of signals input to a mixer stage of FIG. 2;
FIG. 4 illustrates the operation of an RF circuit when a first RF signal is an aggressor signal, according to some embodiments of the present disclosure;
FIG. 5 illustrates an RF circuit according to some embodiments of the present disclosure;
FIG. 6 illustrates an operation of the RF circuit of FIG. 5 when the first RF signal is a wanted signal, according to some embodiments of the present disclosure;
FIG. 7 illustrates an example of signals input to a mixer stage of FIG. 6;
FIG. 8 illustrates an operation of the RF circuit of FIG. 5 when an N-th RF signal is a wanted signal, according to some embodiments of the present disclosure;
FIG. 9 illustrates a comparison of isolation performance between RF circuits according to some embodiments of the present disclosure;
FIG. 10 illustrates an RF circuit according to some embodiments of the present disclosure;
FIG. 11 illustrates an RF circuit according to some embodiments of the present disclosure;
FIG. 12 illustrates the layout of an RF circuit according to some embodiments of the present disclosure; and
FIG. 13 illustrates a wireless communication device according to some embodiments of the present disclosure.

### DETAILED DESCRIPTION OF THE EMBODIMENTS

Hereinafter, embodiments of the present disclosure will be described in detail with reference to the accompanying drawings.

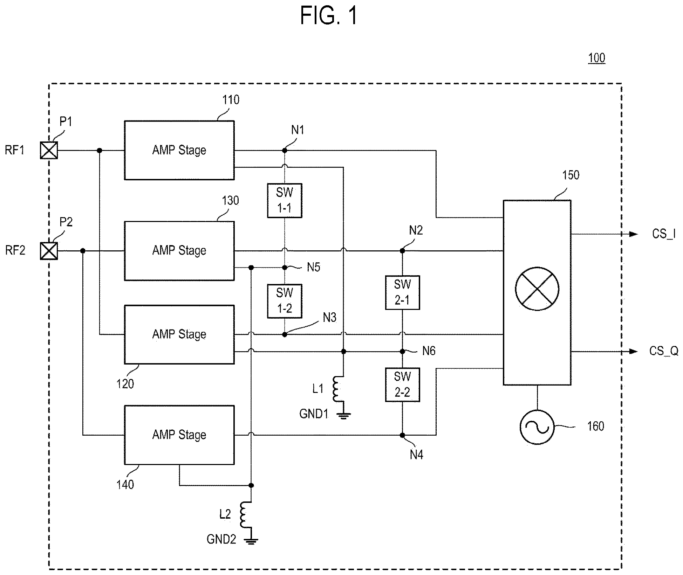

FIG. 1 illustrates a radio frequency (RF) circuit according to an embodiment of the present disclosure.

Referring to FIG. 1, a RF circuit 100 according to an embodiment of the present disclosure may include a plurality of ports P1 and P2, a plurality of amplification stages 110, 120, 130 and 140, a plurality of switches SW1-1, SW1-2, SW2-1 and SW2-2, a mixer stage 150, and an oscillator 160.

The plurality of ports P1 and P2 may be configured to receive RF signals of various bands. For example, RF signals may have a low band (LB), a mid-high band (MHB), an ultra-high band (UHB), a licensed assisted access (LAA) band, an enhanced LAA (eLAA) band, and a new radio unlicensed (NRU) band. The plurality of ports P1 and P2 may be configured to receive an RF signal in a band corresponding to at least one of the above-mentioned bands.

As an example, the plurality of ports P1 and P2 may include the first port P1 and the second port P2. The first port P1 may receive a first RF signal RF1, and the second port P2 may receive a second RF signal RF2. Hereinafter, in the present disclosure, each RF signal may be a wanted signal that must be received through a specific input port, or an unwanted signal (or an aggressor signal) that is not a wanted signal. According to some embodiments, when the first RF signal RF1 is a wanted signal, the second RF signal RF2 may be an unwanted signal. In the alternative, when the first RF signal RF1 is an unwanted signal, the second RF signal RF2 may be a wanted signal. When the first RF signal RF1 is a wanted signal, the first port P1 may be a used port and the second port P2 may be an unused port. In the alternative, when the second RF signal RF2 is a wanted signal, the first port P1 may be an unused port and the second port P2 may be a used port. In this case, it may be required to ensure that an aggressor signal input into an unused port is isolated to a level low enough that it does not affect a wanted signal.

The first RF signal RF1 received through the first port P1 may be transmitted to a (1-1)-th amplification stage 110 and a (1-2)-th amplification stage 120, and the second RF signal RF2 received through the second port P2 may be transmitted to a (2-1)-th amplification stage 130 and a (2-2)-th amplification stage 140.

The plurality of amplification stages 110 to 140 may be configured to amplify RF signals received through the plurality of ports P1 and P2. For example, the plurality of amplification stages 110 to 140 may include the (1-1)-th amplification stage 110, the (1-2)-th amplification stage 120, the (2-1)-th amplification stage 130, and the (2-2)-th amplification stage 140.

For example, each of the plurality of amplification stages 110 to 140 may include at least one matching network and/or an amplifier connected to the at least one matching network. At least one matching network may be provided at an input terminal of a low noise amplifier (LNA) and/or may be provided at an output terminal. At least one matching network may be configured to provide impedance matching for an amplifier. For example, the amplifier may be a buffer or a LNA, and the amplifier may low-noise-amplify the RF signal input to the plurality of amplification stages 110 to 140 and output the amplified RF signal to the mixer stage 150.

The (1-1)-th amplification stage 110 and the (1-2)-th amplification stage 120 may be connected to the first port P1 and a first ground GND1 and may be configured to amplify the first RF signal RF1. Hereinafter, in the present disclosure, the connection of an element to another element may include a case where another element is interposed between the two elements or a case where the element is directly connected to the another element.

A first parasitic inductance L1 may exist in the first ground GND1 to which the (1-1)-th amplification stage 110 and the (1-2)-th amplification stage 120 are connected. The parasitic inductance may be a parasitic component of the semiconductor package on which the RF circuit 100 is mounted. In other words, in the present disclosure, the parasitic inductance is not an actual component of the RF circuit 100, but is simply represented as a parasitic component visible from the RF circuit's 100 ground. For convenience, the parasitic component appearing in the first ground GND1 may be referred to as the first parasitic inductance L1.

The output terminal of the (1-1)-th amplification stage 110 may be connected to the input terminal of the mixer stage 150 through a first node N1, and the (1-1)-th amplification stage 110 may be connected to the first ground GND1 through a sixth node N6. The output terminal of the (1-2)-th amplification stage 120 may be connected to the input terminal of the mixer stage 150 through a third node N3, and similarly, the (1-2)-th amplification stage 120 may be connected to the first ground GND1 through the sixth node N6.

According to some embodiments, when the first RF signal RF1 is an aggressor signal, not only is the first RF signal RF1 input to the mixer stage 150 through the (1-1)-th amplification stage 110 and the (1-2)-th amplification stage 120, but also a component reflected due to the first parasitic inductance L1 may be input to the mixer stage 150. Accordingly, the aggressor signal may need to be offset.

The (2-1)-th amplification stage 130 and the (2-2)-th amplification stage 140 may be connected to the second port P2 and a second ground GND2 to amplify the second RF signal RF2. A second parasitic inductance L2 may exist in the second ground GND2 to which the (2-1)-th amplification stage 130 and the (2-2)-th amplification stage 140 are connected.

The output terminal of the (2-1)-th amplification stage 130 may be connected to the input terminal of the mixer stage 150 through a second node N2, and the (2-1)-th amplification stage 130 may be connected to the second ground GND2 through a fifth node N5. The output terminal of the (2-2)-th amplification stage 140 may be connected to the input terminal of the mixer stage 150 through a fourth node N4, and similarly, the (2-2)-th amplification stage 140 may be connected to the second ground GND2 through the fifth node N5.

According to some embodiments, when the second RF signal RF2 is an aggressor signal, not only is the second RF signal RF2 input to the mixer stage 150 through the (2-1)-th amplification stage 130 and the (2-2)-th amplification stage 140, but also a component reflected due to the second parasitic inductance L2 may be input to the mixer stage 150. Accordingly, the aggressor signal may need to be offset.

To offset the aggressor signal described above, according to some embodiments, a plurality of switches may be provided. The plurality of switches SW1-1 to SW2-2 may include a (1-1)-th switch SW1-1, a (1-2)-th switch SW1-2, a (2-1)-th switch SW2-1, and a (2-2)-th switch SW2-2.

A first terminal of the switch SW1-1 may be connected to the (1-1)-th amplification stage 110 and a second terminal of the switch SW1-1 may be connected to the second ground GND2. A first terminal of the (1-2)-th switch SW1-2 may be connected to the (1-2)-th amplification stage 120 and a second terminal of the switch SW1-2 may be connected to the second ground GND2. In other words, the (1-1)-th switch SW1-1 and the (1-2)-th switch SW1-2 are connected to the second parasitic inductance L2 appearing at the second ground GND2. In detail, the (1-1)-th switch SW1-1 may be connected to the first node N1 and the fifth node N5 connected to the second ground GND2, and the (1-2)-th switch SW1-2 may be connected to the third node N3 and the fifth node N5 connected to the second ground GND2.

Since the opposite terminals (e.g., the second terminals) of the (1-1)-th switch SW1-1 and the (1-2)-th switch SW1-2 are connected to the second ground GND2, when the first RF signal RF1 is an aggressor signal, the (1-1)-th switch SW1-1 and the (1-2)-th switch SW1-2 may operate to apply the RF component (hereinafter, a first RF component) associated with the first RF signal RF1 to the mixer stage 150 through the (2-1)-th amplification stage 130 and the (2-2)-th amplification stage 140.

When the (1-1)-th switch SW1-1 and the (1-2)-th switch SW1-2 are turned on, the RF component associated with the first RF signal RF1 may be reflected due to the second parasitic inductance L2 and transmitted to the (2-1)-th amplification stage 130 and the (2-2)-th amplification stage 140.

In detail, when the first RF signal RF1 is an aggressor signal, the first RF signal RF1 may be transmitted from the output terminals of the (1-1)-th amplification stage 110 and the (1-2)-th amplification stage 120 to the first node N1 and the third node N3. In this case, the first RF signal RF1 may include the RF component reflected from the second parasitic inductance L2. When the (1-1)-th switch SW1-1 and the (1-2)-th switch SW1-2 are turned on, the first RF signal RF1 may be branched at the first node N1 and the third node N3. In this case, a first part of the first RF component may be directly transmitted to the mixer stage 150 through the first node N1 and the third node N3, and a second part of the first RF component may be reflected due to the second parasitic inductance L2 based on the (1-1)-th switch SW1-1 and the (1-2)-th switch SW1-2 being turned on. Accordingly, the first RF component reflected due to the second parasitic inductance L2 may be transmitted to the (2-1)-th amplification stage 130 and the (2-2)-th amplification stage 140 through the fifth node N5. Thereafter, the reflected first RF component may be transmitted to the mixer stage 150 together with the second RF signal RF2. In this case, the first RF components branched from the first node N1 and the third node N3 may have the same phase. Therefore, as will be described later, all of the first RF components may be offset in the mixer stage 150 and only the second RF signal RF2 may be finally output through the RF circuit 100.

The (2-1)-th switch SW2-1 may have a first terminal connected to the (2-1)-th amplification stage 130 and a second terminal connected to the first ground GND1. The (2-2)-th switch SW2-2 may have a first terminal connected to the (2-2)-th amplification stage 140 and a second terminal connected to the first ground GND1. In other words, the (2-1)-th switch SW2-1 and the (2-2)-th switch SW2-2 are connected to the first parasitic inductance L1 appearing at the first ground GND1. In detail, the (2-1)-th switch SW2-1 may be connected to the second node N2 and the sixth node N6 connected to the first ground GND1, and the (2-2)-th switch SW2-2 may be connected to the fourth node N4 and the sixth node N6 connected to the first ground GND1.

When the wanted signal is the second RF signal RF2, the (1-1)-th switch SW1-1 and the (1-2)-th switch SW1-2 may be connected to the second ground GND2, which is a ground included in the wanted signal chain. When the wanted signal is the first RF signal RF1, the (2-1)-th switch SW2-1 and the (2-2)-th switch SW2-2 may be connected to the first ground GND1, which is a ground included in the wanted signal chain.

Since opposite terminals (e.g., the second terminals) of the (2-1)-th switch SW2-1 and the (2-2)-th switch SW2-2 are connected to the first ground GND1, when the second RF signal RF2 is an aggressor signal, the (2-1)-th switch SW2-1 and the (2-2)-th switch SW2-2 may operate to apply the RF component (hereinafter, referred to as the second RF component) associated with the second RF signal RF2 to the mixer stage 150 through the (1-1)-th amplification stage 110 and the (1-2)-th amplification stage 120.

In detail, when the second RF signal RF2 is an aggressor signal, the second RF signal RF2 may be transmitted from the output terminals of the (2-1)-th amplification stage 130 and the (2-2)-th amplification stage 140 to the second node N2 and the fourth node N4. In this case, the second RF signal RF2 may include the RF component reflected from the second parasitic inductance L2. When the (2-1)-th switch SW2-1 and the (2-2)-th switch SW2-2 are turned on, the second RF signal RF2 may be branched at the second node N2 and the fourth node N4. In this case, a first part of the second RF component may be directly transmitted to the mixer stage 150 through the second node N2 and the fourth node N4, and a second part of the second RF component may be reflected due to the first parasitic inductance L1 based on the (2-1)-th switch SW2-1 and the (2-2)-th switch SW2-2 being turned on. Accordingly, the second RF component reflected due to the first parasitic inductance L1 may be transmitted to the (1-1)-th amplification stage 110 and the (1-2)-th amplification stage 120 through the sixth node N6. Thereafter, the reflected second RF component may be transmitted to the mixer stage 150 together with the first RF signal RF 1. In this case, the second RF components branched from the second node N2 and the fourth node N4 may have the same phase. Therefore, as will be described later, all second RF components may be offset in the mixer stage 150 and only the first RF signal RF1 may be finally output through the RF circuit 100.

The mixer stage 150 may be configured to mix the first RF signal RF1 or the second RF signal RF2 with a local oscillator (LO) signal. For example, when the RF circuit 100 of FIG. 1 corresponds to a reception path, the mixer stage 150 may down convert the first RF signal RF1 or the second RF signal RF2. The oscillator 160 may be connected to the mixer stage 150 to provide the LO signal. The oscillator 160 may generate an LO signal having an appropriate LO frequency for down-conversion according to the bandwidth of each of the first RF signal RF1 and the second RF signal RF2 and provide the LO signal to the mixer stage 150.

According to some embodiments, the mixer stage 150 may be implemented as a double balanced mixer (DBM). The mixer stage 150 may be connected to the (1-1)-th amplification stage 110 and the (2-1)-th amplification stage 130 and be configured to mix the first RF signal RF1 or the second RF signal RF2 with the LO signal. The mixer stage 150 may be connected to the first node N1 corresponding to the output terminal of the (1-1)-th amplification stage 110 and the third node N3 corresponding to the output terminal of the (1-2)-th amplification stage 130. The mixer stage 150 may be connected to the (1-2)-th amplification stage 120 and the (2-2)-th amplification stage 140 and be configured to similarly mix the first RF signal RF1 or the second RF signal RF2 with the LO signal. The mixer stage 150 may be connected to the second node N2 corresponding to the output terminal of the (1-2)-th amplification stage 120 and the fourth node N4 corresponding to the output terminal of the (2-2)-th amplification stage 140.

According to some embodiments, when the (1-1)-th switch SW1-1 and the (1-2)-th switch SW1-2 are turned on, and the (2-1)-th switch SW2-1 and the (2-2)-th switch SW2-2 are turned off (e.g., when the first RF signal RF1 is an aggressor signal), a first part of the first RF components may be applied to some input terminals of the mixer stage 150, and a second part of the first RF components may be applied to some input terminals of the mixer stage 150 together with the second RF signal RF2. In this case, as described above, because the first RF components applied to different input terminals have the same phase, the mixer stage 150 may offset all of the applied first RF components. For example, the mixer stage 150 may be implemented as a differential mixer to offset the first RF component.

According to some embodiments, when the (1-1)-th switch SW1-1 and the (1-2)-th switch SW1-2 are turned off, and the (2-1)-th switch SW2-1 and the (2-2)-th switch SW2-2 are turned on (e.g., when the second RF signal RF2 is an aggressor signal), a first part of the second RF components may be applied to some input terminals of the mixer stage 150, and a second part of the second RF components may be applied to some input terminals of the mixer stage 150 together with the first RF signal RF1. In this case, as described above, because the second RF components applied to different input terminals have the same phase, the mixer stage 150 may offset all of the applied second RF components. For example, the mixer stage 150 may be implemented as a differential mixer to offset the second RF component.

Through the mixer stage 150, in-phase/quadrature (I/Q) conversion signals CS_I and CS_Q converted based on the LO frequency may be output.

According to the above-described embodiments, when receiving multiple input signals of various bands, the RF circuit 100 of the present disclosure may receive only the wanted signal by isolating the aggressor signal among signals input simultaneously through several input ports. In particular, the present disclosure includes a switch inside the RF circuit 100 that intentionally distributes the aggressor signal into RF components having the same phase and inputs the aggressor signal to the mixer stage 150, thereby making it possible to isolate the aggressor signal without using external elements. In addition, because the present disclosure does not require directly removing the parasitic inductance of a semiconductor package, the versatility of circuit design may be increased.

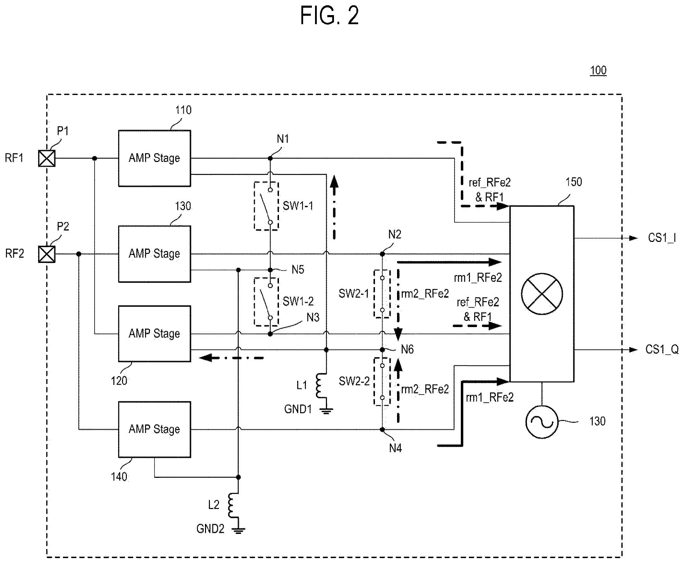

FIG. 2 illustrates the operation of an RF circuit when the second RF signal is an aggressor signal, according to some embodiments of the present disclosure. Hereinafter, detailed descriptions of parts overlapping with FIG. 1 will be omitted.

Referring to FIG. 2, when the first RF signal RF 1 input through the first port P1 is a wanted signal, the second RF signal RF2 input through the second port P2 is an aggressor signal. To isolate the second RF signal RF2 to mix the first RF signal RF1 with the LO signal, the (1-1)-th switch SW1-1 and the (1-2)-th switch SW1-2 may be turned off (e.g., opened) and the (2-1)-th switch SW2-1 and the (2-2)-th switch SW2-2 may be turned on (e.g., closed). When the (1-1)-th switch SW1-1 and the (1-2)-th switch SW1-2 are turned off, the first node N1 is disconnected from the fifth node N5, and the third node N3 is disconnected from the fifth node N5.

The second RF signal RF2, which is an aggressor signal, may be transmitted to the second node N2 and the fourth node N4 through the (2-1)-th amplification stage 130 and the (2-2)-th amplification stage 140. In this case, the transmitted second RF signal RF2 may include an RF component reflected due to the second parasitic inductance L2. Thereafter, since the (2-1)-th switch SW2-1 and the (2-2)-th switch SW2-2 are turned on, the second RF signal RF2 may be branched into a first part of the remaining second RF component (hereinafter, referred to as a remaining (2-1)-th RF component rm1_RFe2) and a second part of the remaining second RF component (hereinafter, referred to as a remaining (2-2)-th RF component rm2_RFe2) at the second node N2 and the fourth node N4. In this case, both the remaining (2-1)-th RF component rm1_RFe2 and the remaining (2-2)-th RF component rm2_RFe2 may be included in the second RF component. The remaining (2-1)-th RF component rm1_RFe2 and the remaining (2-2)-th RF component rm2_RFe2 may have a lower signal size than the second RF signal RF2 before its branching and may have the same phase. The remaining (2-1)-th RF component rm1_RFe2 may be applied to the mixer stage 150.

The remaining (2-2)-th RF component rm2_RFe2 may be reflected from the first ground GND1 and the first parasitic inductance L1 through the sixth node N6 based on the (2-1)-th switch SW2-1 and the (2-2)-th switch SW2-2 being turned on. Therefore, the reflected second RF component ref_RFe2 may be applied to the mixer stage 150 together with the first RF signal RF1 through the (1-1)-th amplification stage 110 and the (1-2)-th amplification stage 120. Ultimately, based on the fact that the (2-1)-th switch SW2-1 and the (2-2)-th switch SW2-2 are turned on, the second RF component ref_RFe2 reflected from the first ground GND1 among the second RF component may be transmitted to the mixer stage 150.

In this case, the reflected second RF component ref_RFe2 and the remaining (2-1)-th RF component rm1_RFe2 may have the same phase. Therefore, the mixer stage 150 may offset the reflected second RF component ref_RFe2 and the remaining (2-1)-th RF component rm1_RFe2 input through the (2-1)-th amplification stage 130. In addition, the mixer stage 150 may offset the reflected second RF component ref_RFe2 and the remaining (2-1)-th RF component rm1_RFe2 input through the (2-2)-th amplification stage 140. The mixer stage 150 may offset the second RF components, convert the first RF signal RF1, and output a first I converted signal CS1_I and a first Q converted signal CS1_Q.

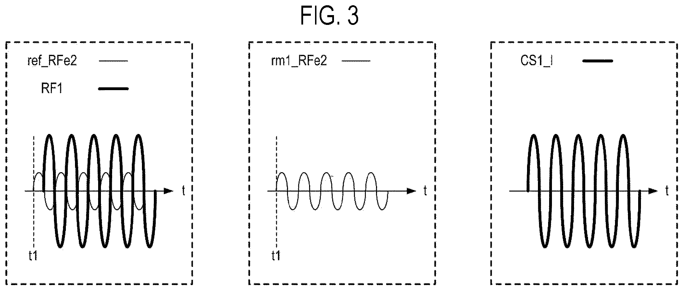

FIG. 3 illustrates an example of signals input to the mixer stage of FIG. 2.

Referring to FIG. 3, the second RF component ref_RFe2 reflected together with the first RF signal RF1 may be applied to the mixer stage 150, and for example, the reflected second RF component ref_RFe2 may be shown as a waveform having a time period starting at an arbitrary time point of t1 (where t1 is a real number greater than 0 (zero)). In this case, like the reflected second RF component ref_RFe2, the remaining (2-1)-th RF component rm1_RFe2 may have a time period starting at the arbitrary time point of t1, and therefore, the phase difference between the reflected second RF component ref_RFe2 and the remaining (2-1)-th RF component rm1_RFe2 may be 0 (zero). In other words, these signals may be in phase.

Ultimately, the reflected second RF component ref_RFe2 and the remaining (2-1)-th RF component rm1_RFe2 may be offset through the mixer stage 150, so that the second RF component may not be present in the final output conversion signal (e.g., the first I converted signal CS1_I). In other words, because the aggressor signal components input to the mixer stage 150 have the same phase, they can be differentially cancelled out by the mixer stage 150. As a result, only the wanted signal may be output through the mixer stage 150.

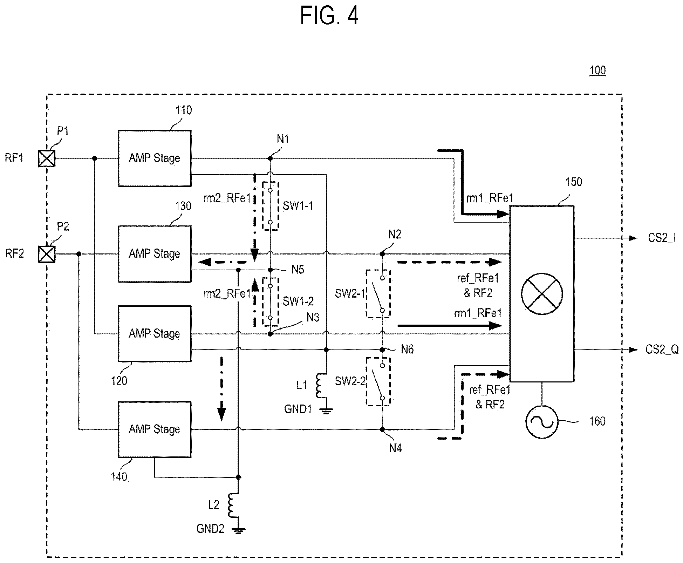

FIG. 4 illustrates the operation of an RF circuit when the first RF signal is an aggressor signal, according to some embodiments of the present disclosure.

Referring to FIG. 4, when the second RF signal RF2 input through the second port P2 is a wanted signal, the first RF signal RF1 input through the first port P1 is an aggressor signal. To isolate the first RF signal RF1 to mix the second RF signal RF2 with the LO signal, the (2-1)-th switch SW2-1 and the (2-2)-th switch SW2-2 may be turned off and the (1-1)-th switch SW1-1 and the (1-2)-th switch SW1-2 may be turned on. When the (2-1)-th switch SW2-1 and the (2-2)-th switch SW2-2 are turned off, the second node N2 is disconnected from the sixth node N6, and the fourth node N4 is disconnected from the sixth node N6.

The first RF signal RF1, which is an aggressor signal, may be transmitted to the first node N1 and the third node N3 through the (1-1)-th amplification stage 110 and the (1-2)-th amplification stage 120. In this case, the transmitted first RF signal RF1 may include an RF component reflected due to the first parasitic inductance L1. Thereafter, since the (1-1)-th switch SW1-1 and the (1-2)-th switch SW1-2 are turned on, the first RF signal RF1 may be branched into a first part of the remaining first RF component (hereinafter, referred to as a remaining (1-1)-th RF component rm1_RFe1) and a second part of the remaining first RF component (hereinafter, referred to as a remaining (1-2)-th RF component rm2_RFe1) at the first node N1 and the third node N3. In this case, both the remaining (1-1)-th RF component rm1_RFe1 and the remaining (1-2)-th RF component rm2_RFe1 may be included in the first RF component. The remaining (1-1)-th RF component rm1_RFe1 and the remaining (1-2)-th RF component rm2_RFe1 may have a lower signal size than the first RF signal RF1 before its branching and may have the same phase. The remaining (1-1)-th RF component rm1_RFe1 may be applied to the mixer stage 150.

The remaining (1-2)-th RF component rm2_RFe1 may be reflected from the second ground GND2 and the second parasitic inductance L2 through the fifth node N5 based on the (1-1)-th switch SW1-1 and the (1-2)-th switch SW1-2 being turned on. Therefore, the reflected first RF component ref_RFe1 may be applied to the mixer stage 150 together with the second RF signal RF2 through the (2-1)-th amplification stage 130 and the (2-2)-th amplification stage 140. Ultimately, based on the fact that the (1-1)-th switch SW1-1 and the (1-2)-th switch SW1-2 are turned on, the first RF component ref_RFe1 reflected from the second ground GND2 among the first RF components may be transmitted to the mixer stage 150.

In this case, the reflected first RF component ref_RFe1 and the remaining (1-1)-th RF component rm1_RFe1 may have the same phase. Therefore, the mixer stage 150 may offset the reflected first RF component ref_RFe1 and the remaining (1-1)-th RF component rm1_RFe1 input through the (1-1)-th amplification stage 110. In addition, the mixer stage 150 may offset the reflected first RF component ref_RFe1 and the remaining (1-1)-th RF component rm1_RFe1 input through the (1-2)-th amplification stage 120. The mixer stage 150 may offset the first RF components, convert the second RF signal RF2, and output a second I converted signal CS2_I and a second Q converted signal CS2_Q. In this case, the second RF component may not be present in the finally output second I converted signal and second Q converted signal CS2_I and CS2_Q. In other words, because the aggressor signal components input to the mixer stage 150 have the same phase, they can be differentially canceled out by the mixer stage 150. As a result, only the wanted signal may be output through the mixer stage 150.

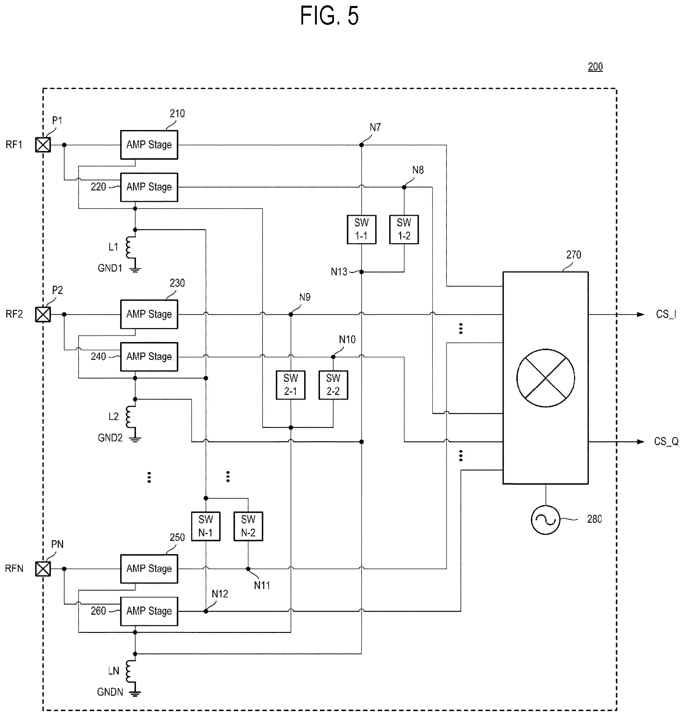

FIG. 5 illustrates an RF circuit according to some embodiments of the present disclosure.

Referring to FIG. 5, an RF circuit 200 may include N ports P1 to PN, a plurality of amplification stages 210, 220, 230, 240, 250 and 260 corresponding to the N ports P1 to PN, a plurality of switches SW1-1, SW1-2, SW2-1, SW2-2, SWN-1 to SWN-2 configured to intentionally apply an aggressor signal to a wanted signal applied to each of the N ports P1 to PN, and a mixer stage 270. An oscillator 280 for providing an LO signal may be connected to the mixer stage 270.

A first RF signal RF1, and a second RF signal RF2 to a N-th RF signal RFN may be sequentially received at each of the N ports P1 to PN. According to various embodiments, when one of the first RF signal RF1, and the second RF signal RF2 to the N-th RF signal RFN is a wanted signal, the remaining RF signals may be aggressor signals.

Two amplification stages may be connected to each of the N ports P1 to PN. For example, the (1-1)-th amplification stage 210 and the (1-2)-th amplification stage 220 may be connected to the first port P1. The (2-1)-th amplification stage 230 and the (2-2)-th amplification stage 240 may be connected to the second port P2, and the (N-1)-th amplification stage 250 and the (N-2)-th amplification stage 260 may be connected to the N-th port PN.

The (1-1)-th amplification stage 210 and the (1-2)-th amplification stage 220 may be connected to the first ground GND1. The (2-1)-th amplification stage 230 and the (2-2)-th amplification stage 240 may be connected to the second ground GND2. The (N-1)-th amplification stage 250 and the (N-2)-th amplification stage 260 may be connected to a N-th ground GNDN. The first parasitic inductance L1, the second parasitic inductance L2, and an N-th parasitic inductance LN may exist in the first ground GND1, the second ground GND2, and the N-th ground GNDN, respectively.

The output terminal of the (1-1)-th amplification stage 210 may be connected to the input terminal of the mixer stage 270 through a seventh node N7, and the (1-1)-th amplification stage 210 may be connected to the first ground GND1through a thirteenth node N13. The output terminal of the (1-2)-th amplification stage 220 may be connected to the input terminal of the mixer stage 270 through an eighth node N8, and similarly, the (1-2)-th amplification stage 220 may be connected to the first ground GNDlthrough the thirteenth node N13. The output terminal of the (2-1)-th amplification stage 230 may be connected to the input terminal of the mixer stage 270 through a ninth node N9, and the (2-1)-th amplification stage 230 may be connected to the second ground GND2 through the thirteenth node N13. The output terminal of the (2-2)-th amplification stage 240 may be connected to the input terminal of the mixer stage 270 through a tenth node N10, and similarly, the (2-2)-th amplification stage 240 may be connected to the second ground GND2 through the thirteenth node N13. The output terminal of the (N-1)-th amplification stage 250 may be connected to the input terminal of the mixer stage 270 through an eleventh node N11, and the (N-1)-th amplification stage 250 may be connected to the N-th ground GNDN through the thirteenth node N13. The output terminal of the (N-2)-th amplification stage 260 may be connected to the input terminal of the mixer stage 270 through a twelfth node N12, and similarly, the (N-2)-th amplification stage 260 may be connected to the N-th ground GNDN through the thirteenth node N13.

The plurality of switches SW1-1 to SWN-2 may include a (1-1)-th switch SW1-1, a (1-2)-th switch SW1-2, a (2-1)-th switch SW2-1, a (2-2)-th switch SW2-2 to an (N-1)-th switch SWN-1, and an (N-2)-th switch SWN-2.

The (1-1)-th switch SW1-1 may have a first terminal connected to the (1-1)-th amplification stage 210 through the seventh node N7 and a second terminal connected to the second ground GND2 and the N-th ground GNDN through the thirteenth node N13. The (1-2)-th switch SW1-2 may have a first terminal connected to the (1-2)-th amplification stage 220 through the eighth node N8 and a second terminal connected to the second ground GND2 and the N-th ground GNDN through the thirteenth node N13. The (2-1)-th switch SW2-1 may have a first terminal connected to the (2-1)-th amplification stage 230 through the ninth node N9 and a second terminal connected to the first ground GND1 and the N-th ground GNDN through the thirteenth node N13. The (2-2)-th switch SW2-2 may have a first terminal connected to the (2-2)-th amplification stage 240 through the tenth node N10 and a second terminal connected to the first ground GND1 and the N-th ground GNDN through the thirteenth node N13.

The (N-1)-th switch SWN-1 may have a first terminal connected to the (N-1)-th amplification stage 260 through the twelfth node N12 and a second terminal connected to the first ground GND1, the second ground GND2 and the N-th gound GNDN through the thirteenth node N13.

The (N-2)-th switch SWN-2 may have a first terminal connected to the (N-2)-th amplification stage 250 through the eleventh node N11 and a second terminal connected to the first ground GND1, the second ground GND2 and the N-th gound GNDN through the thirteenth node N13. In other words, each of the plurality of switches SW1-1 to SWN-2 may be configured such that an opposite terminal (e.g., a second terminal) is connected to the grounds.

RF signals may be applied to the input terminal of the mixer stage 270 from the (1-1)-th amplification stage 210, the (2-1)-th amplification stage 230 to the (N-1)-th amplification stage 250, and RF signals may be input from the (1-2)-th amplification stage 220, and the (2-2)-th amplification stage 240 to the (N-2)-th amplification stage 260 to the input terminal of the mixer stage 270.

According to some embodiments, in the RF circuit 200 of FIG. 5, the plurality of ports P1 to PN may receive first to N-th RF signals RF1 to RFN. The plurality of amplification stages 210 to 260 may be connected to the plurality of ports P1 to PN and the first to N-th ground GND1 to GNDN to amplify the first to N-th RF signals RF1 to RFN. A first terminal of each of the plurality of switches SW1-1 to SWN-2 may be connected to one of the plurality of amplification stages 210 to 260, and a second terminal of each of the plurality of switches SW1-1 to SWN-2 may be connected to all grounds. The mixer stage 270 may be connected to the plurality of amplification stages 210 to 260 and mix one RF signal with the LO signal to offset the remaining RF signals.

For example, based on mixing one RF signal amplified through one of the plurality of amplification stages 210 to 260, at least one of the plurality of switches SW1-1 to SWN-2 connected to one amplification stage may be turned off, and the remaining switches except for at least one of the plurality of switches SW1-1 to SWN-2 may be turned on.

For example, since the remaining switches are turned on, RF components reflected from the remaining grounds among the RF components associated with the remaining RF signals may be transmitted to the mixer stage 270.

For example, the mixer stage 270 may offset the reflected RF components and the remaining RF components input through the remaining amplification stages among the plurality of amplification stages 210 to 260.

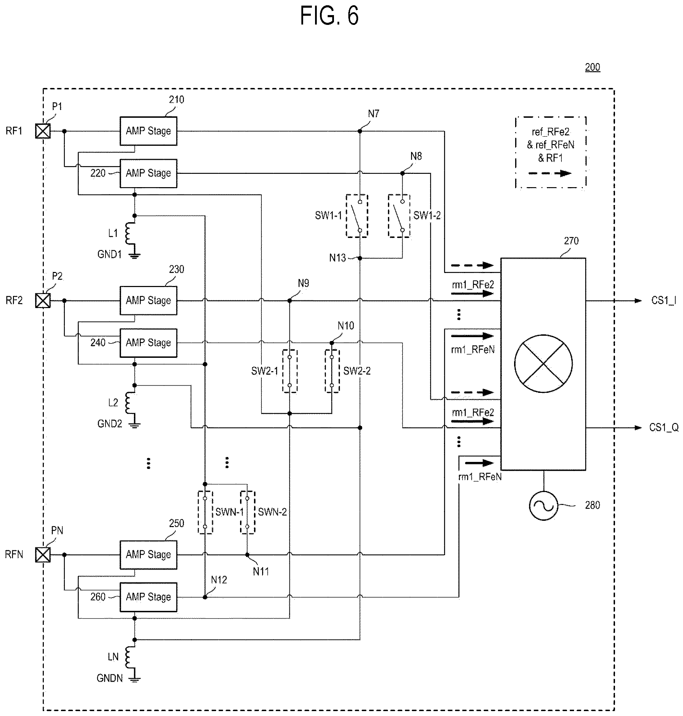

FIG. 6 illustrates an operation of the RF circuit of FIG. 5 when the first RF signal is a wanted signal, according to some embodiments of the present disclosure.

Referring to FIG. 6, when the first RF signal RF 1 input through the first port P1 is a wanted signal, the second RF signal RF2 input through the second port P2 and the N-th RF signal RFN input through the N-th port PN are an aggressor signal. When isolation of the second RF signal RF2 and the N-th RF signal RFN is required to mix the first RF signal RF1 with the LO signal, the (1-1)-th switch SW1-1 and the (1-2)-th switch SW1-2 may be turned off, and the (2-1)-th switch SW2-1, the (2-2)-th switch SW2-2, the (N-1)-th switch SWN-1, and the (N-2)-th switch SWN-2 may be turned on. When the (1-1)-th switch SW1-1 and the (1-2)-th switch SW1-2 are turned off, the seventh node N7 is disconnected from the thirteenth node N13, and the eighth node N8 is disconnected from the thirteenth node N13.

The second RF signal RF2, which is an aggressor signal, may be transmitted to the ninth node N9 and the tenth node N10 through the (2-1)-th amplification stage 230 and the (2-2)-th amplification stage 240. In this case, the transmitted second RF signal RF2 may include an RF component reflected due to the second parasitic inductance L2. In addition, the N-th RF signal RFN may be transmitted to the eleventh node N11 and the twelfth node N12 through the (N-1)-th amplification stage 250 and the (N-2)-th amplification stage 260. In this case, the transmitted N-th RF signal RFN may include an RF component reflected due to the N-th parasitic inductance LN.

Thereafter, since the (2-1)-th switch SW2-1 and the (2-2)-th switch SW2-2 are turned on, the second RF signal RF2 may be branched into the remaining (2-1)-th RF component rm1_RFe2 and the remaining (2-2)-th RF component rm2_RFe2 having the same phase at the ninth node N9 and the tenth node N10. The remaining (2-1)-th RF component rm1_RFe2 may be applied to the mixer stage 270. In addition, since the (N-1)-th switch SWN-1 and the (N-2)-th switch SWN-2 are turned on, the N-th RF signal RFN may be branched into the remaining (N-1)-th RF component rm1_RFeN and the remaining (N-2)-th RF component rm2_RFeN having the same phase at the eleventh node N11 and the twelfth node N12. The remaining (N-1)-th RF component rm1_RFeN may be applied to the mixer stage 270.

The remaining (2-2)-th RF component rm2_RFe2 may be reflected from the first ground GND1 and the first parasitic inductance L1 through the thirteenth node N13 based on the (2-1)-th switch SW2-1 and the (2-2)-th switch SW2-2 being turned on, and the remaining (N-2)-th RF component rm2_RFeN may be reflected from the first ground GND1 and the first parasitic inductance L1 through the thirteenth node N13 based on the (N-1)-th switch SWN-1 and the (N-2)-th switch SWN-2 being turned on. Therefore, the reflected second RF component ref_RFe2 and the reflected N-th RF component ref_RFeN may be applied to the mixer stage 270 through the (1-1)-th amplification stage 210 and the (1-2)-th amplification stage 220 together with the first RF signal RF1.

In this case, the reflected second RF component ref_RFe2 and the remaining (2-1)-th RF component rm1_RFe2 may have the same phase, and the reflected N-th RF component ref_RFeN and the remaining (N-1)-th RF component rm1_RFeN may also have the same phase. Therefore, the mixer stage 270 may offset the reflected second RF component ref_RFe2 and the remaining (2-1)-th RF component rm1_RFe2 input through the (2-1)-th amplification stage 230, and offset the reflected N-th RF component ref_RFeN and the remaining (N-1)-th RF component rm1_RFeN input through the (N-1)-th amplification stage 250. Likewise, the mixer stage 270 may offset the reflected second RF component ref_RFe2 and the remaining (2-1)-th RF component rm1_RFe2 input through the (2-2)-th amplification stage 240, and offset the reflected N-th RF component ref_RFeN and the remaining (N-1)-th RF component rm1_RFeN input through the (N-2)-th amplification stage 260. The mixer stage 270 may offset the second RF components and the N-th RF components, convert the first RF signal RF1, and output the first I converted signal CS1_I and the first Q converted signal CS1_Q.

In addition, although not described, the third to (N-1)-th RF components are also offset through the mixer stage 270 according to the above-described embodiments.

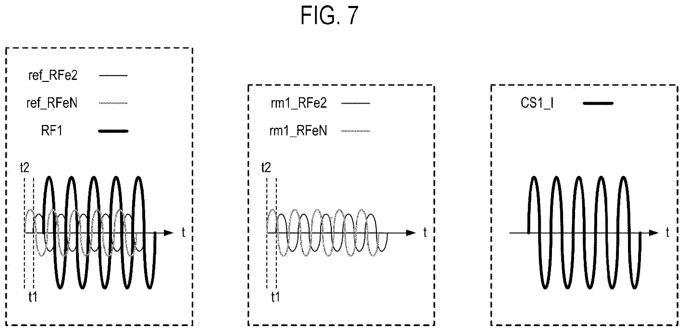

FIG. 7 illustrates an example of signals input to the mixer stage of FIG. 6.

Referring to FIG. 6, the reflected second RF component ref_RFe2 and the reflected N-th RF component ref_RFeN together with the first RF signal RF1 may be applied to the mixer stage 270. For example, the reflected second RF component ref_RFe2 is shown as a waveform with a time period starting at an arbitrary time point of t1 (where t1 is a real number greater than 0 (zero)), and the reflected N-th RF component ref_RFeN is shown as a waveform with a time period starting at an arbitrary time point of t2 (where t2 is a real number greater than or equal to 0 (zero)). In this case, like the reflected second RF component ref_RFe2, the remaining (2-1)-th RF component rm1_RFe2 may also have a time period starting at an arbitrary time point of t1, so that the phase difference between the reflected second RF component ref_RFe2 and the remaining (2-1)-th RF component rm1_RFe2 is 0, in other words, these signals have the same phase. In addition, like the reflected N-th RF component ref_RFeN, the remaining (N-1)-th RF component rm1_RFeN may have a time period starting at an arbitrary time point of t2, so that the phase difference between the reflected N-th RF component ref_RFeN and the remaining N-th RF component rm1_RFeN is 0 (zero), in other words, these signals have the same phase.

Ultimately, the reflected second RF component ref_RFe2 and the remaining (2-1)-th RF component rm1_RFe2 may offset each other through the mixer stage 270, and the reflected N-th RF component ref_RFeN and the remaining (N-1)-th RF component rm1_RFeN may offset each other through the mixer stage 270. As a result, the second RF component and the N-th RF component may not exist in the finally output converted signal (e.g., the first I converted signal CS1_I). In other words, because the aggressor signal components input to the mixer stage 270 have the same phase, the aggressor signal components may be differentially removed by the mixer stage 270 so that only the wanted signal may be output finally through the mixer stage 270.

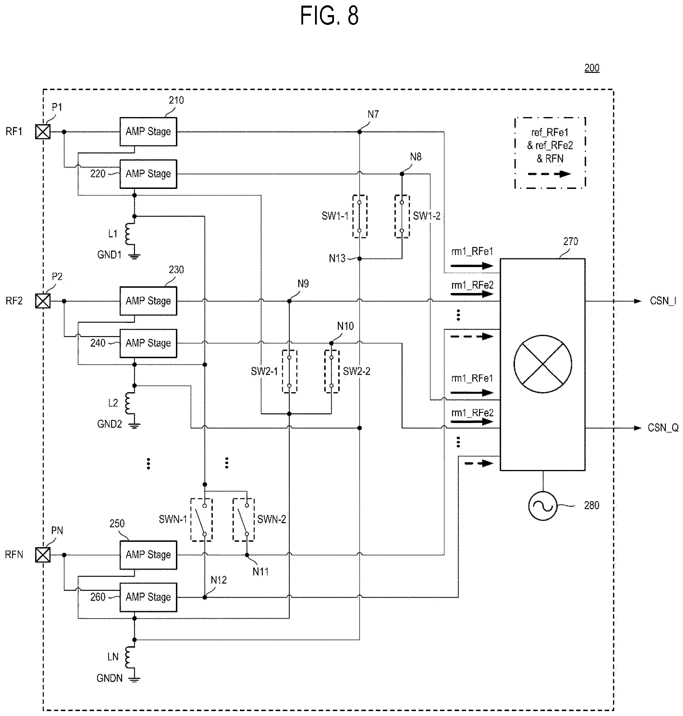

FIG. 8 illustrates an operation of the RF circuit of FIG. 5 when the N-th RF signal is a wanted signal, according to some embodiments of the present disclosure.

Referring to FIG. 8, when the N-th RF signal RFN input through the N-th port PN is a wanted signal, the first RF signal RF1 input through the first port P1 and the second RF signal RF2 input through the second port P2 is an aggressor signals. When isolation of the first RF signal RF1 and the second RF signal RF2 is required to mix the N-th RF signal RFN with the LO signal, the (N-1)-th switch SWN-1 and the (N-2)-th switch SWN-2 may be turned off, and the (1-1)-th switch SW1-1, the (1-2)-th switch SW1-2, the (2-1)-th switch SW2-1, and the (2-2)-th switch SW2-2) may be turned on. When the (N-1)-th switch SWN-1 and the (N-2)-th switch SWN-2 are turned off, the eleventh node N11 is disconnected from the thirteenth node N13, and the twelfth node N12 is disconnected from the thirteenth node N13.

The first RF signal RF1, which is an aggressor signal, may be transmitted to the seventh node N7 and the eighth node N8 through the (1-1)-th amplification stage 210 and the (1-2)-th amplification stage 220. In this case, the transmitted first RF signal RF1 may include an RF component reflected due to the first parasitic inductance L1. In addition, the second RF signal RF2 may be transmitted to the ninth node N9 and the tenth node N10 through the (2-1)-th amplification stage 230 and the (2-2)-th amplification stage 240. In this case, the transmitted second RF signal RF2 may include an RF component reflected due to the second parasitic inductance L2.

Thereafter, since the (1-1)-th switch SW1-1 and the (1-2)-th switch SW1-2 are turned on, the first RF signal RF1 may be branched into a remaining (1-1)-th RF component rm1_RFe1 and a remaining (1-2)-th RF component rm2_RFe1 having the same phase. The remaining (1-1)-th RF component rm1_RFe1 may be applied to the mixer stage 270. In addition, since the (2-1)-th switch SW2-1 and the (2-2)-th switch SW2-2 are turned on, the second RF signal RF2 may be branched into the remaining (2-1)-th RF component rm1_RFe2 and the remaining (2-2)-th RF component rm2_RFe2 having the same phase at the ninth node N9 and the tenth node N10. The remaining (2-1)-th RF component rm1_RFe2 may be applied to the mixer stage 270.

Since the (1-1)-th switch SW1-1 and the (1-2)-th switch SW1-2 are turned on, the remaining (1-2)-th RF component rm2_RFe1 may be reflected from the N-th ground GNDN and the N-th parasitic inductance LN through the thirteenth node N13. Since the (2-1)-th switch SW2-1 and the (2-2)-th switch SW2-2 are turned on, the remaining (2-2)-th RF component rm2_RFe2 may be reflected from the N-th ground GNDN and the N-th parasitic inductance LN through the thirteenth node N13. Therefore, the reflected first RF component ref_RFe1 and the reflected second RF component ref_RFe2 may be applied to the mixer stage 270 through the (N-1)-th amplification stage 250 and the (N-2)-th amplification stage 260 together with the N-th RF signal RFN.

In this case, the reflected first RF component ref_RFe1 and the remaining (1-1)-th RF component rm1_RFe1 may have the same phase, and the reflected second RF component ref_RFe2 and the remaining (2-1)-th RF component rm1_RFe2 may also have the same phase. Therefore, the mixer stage 270 may offset the reflected first RF component ref_RFe1 and the remaining (1-1)-th RF component rm1_RFe1 input through the (1-1)-th amplification stage 210, and offset the reflected second RF component ref_RFe2 and the remaining (2-1)-th RF component rm1_RFe2 input through the (2-1)-th amplification stage 230. Likewise, the mixer stage 270 may offset the reflected first RF component ref_RFe1 and the remaining (1-1)-th RF component rm1_RFe1 input through the (1-2)-th amplification stage 220, and offset the reflected second RF component ref_RFe2 and the remaining (2-1)-th RF component rm1_RFe2 input through the (2-2)-th amplification stage 240. The mixer stage 270 may offset the first RF components and the second RF components, convert the N-th RF signal RFN, and output the N-th I converted signal CSN_I and the N-th Q converted signal CSN_Q.

According to the above-described embodiments, when receiving multiple input signals of various bands, the RF circuit 200 of the present disclosure may isolate the aggressor signals except for a wanted signal, which corresponds to one input port, among signals simultaneously input through several input ports, thereby receiving only the wanted signal. In particular, the present disclosure may include a switch configured to intentionally distribute each aggressor signal into RF components having the same phase and input them to the mixer stage 270, thereby isolating all of the aggressor signals without requiring external elements.

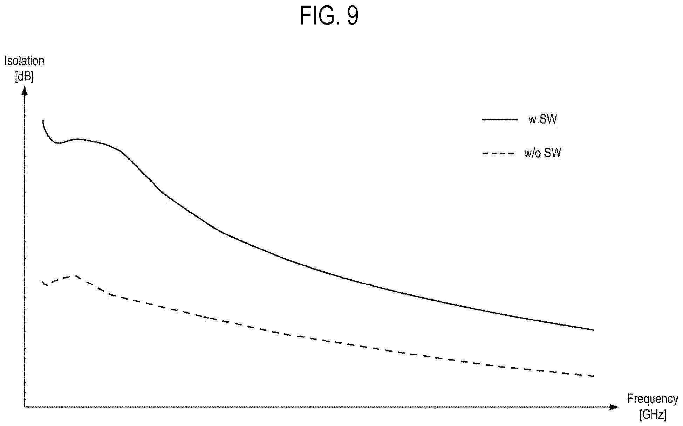

FIG. 9 illustrates a comparison of isolation performance between RF circuits according to some embodiments of the present disclosure.

Referring to FIG. 9, comparing the isolation performance by frequency of an RF circuit w SW with a switch and an RF circuit w/o SW without a switch according to some embodiments of the present disclosure, it may be confirmed that the isolation performance is improved in all frequency bands when a switch is provided like the RF circuit of the present disclosure.

When a switch is not provided inside the RF circuit, a switch may be provided outside the RF circuit (e.g., a front-terminal module (FEM) stage, and the like) to isolate an aggressor signal. However, when the switch is implemented with a switching element such as a transistor, the switching element may not physically turn the path on/off, and thus, an aggressor signal may flow into the RF circuit. In this case, the input aggressor signal may include a reflected component due to the parasitic inductance caused by a semiconductor package, as described above. Since the signal is in a higher frequency band, the size of the reflected component may increase as the impedance of the parasitic inductance increases. Ultimately, there may be limits to securing isolation when an external switch is provided.

To the contrary, according to the present disclosure, the aggressor signal may be applied together with the wanted signal through the switch provided inside the RF circuit, and the aggressor signal may be actively removed through the mixer that receives the aggressor signal together with the aggressor signal having the same phase as the applied aggressor signal. Therefore, according to the present disclosure, it is possible to secure improved isolation performance regardless of the frequency band of the signal, and in particular, as shown, to overcome isolation degradation due to parasitic inductance even at high frequencies.

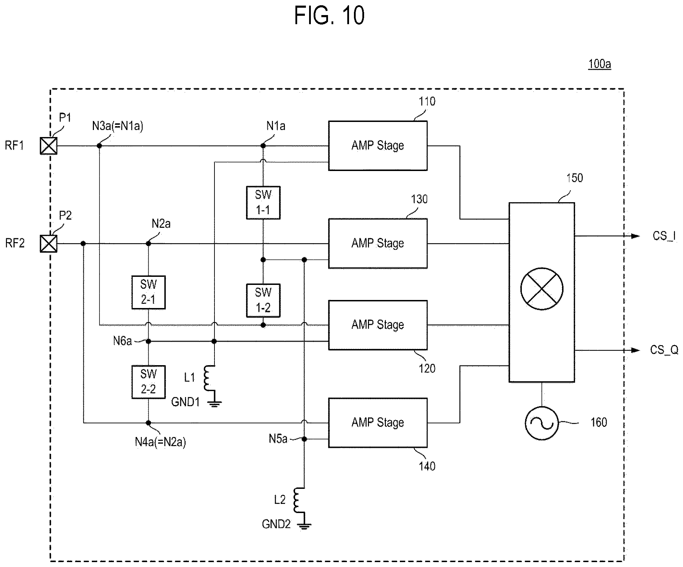

FIG. 10 illustrates an RF circuit according to some embodiments of the present disclosure. Hereinafter, detailed descriptions of parts overlapping with FIG. 1 will be omitted.

Referring to FIG. 10, according to some embodiments, the plurality of switches SW1-1 to SW2-2 described above may be provided on front ends of the plurality of amplification stages 110 to 140, in other words, between the plurality of ports P1 and P2 and the plurality of amplification stages 110 to 140. In this configuration, the first port P1 may be connected to the input terminal of the first amplification stage 110 through a 1a-th node N1a, and the second port P2 may be connected to the input terminal of the third amplification stage 130 through a 2a-th node N2a. The (1-1)-th switch SW1-1 may be connected to the 1a-th node N1a and a 5a-th node N5a, and the (1-2)-th switch SW1-2 may be connected to the 5a-th node N5a and a 3a-th node N3a. In this case, the 3a-th node N3a may be the same as the 1a-th node N1a. The (2-1)-th switch SW2-1 may be connected to the 2a-th node N2a and a 6a-th node N6a, and the (2-2)-th switch SW2-2 may be connected to the 6a-th node N6a and a 4a-th node N4a. In this case, the 4a-th node N4a may be the same as the 2a-th node N2a.

The output terminals of the plurality of amplification stages 110 to 140 may be directly connected to the mixer stage 150.

The input terminal of the first amplification stage 110 may be connected to the first port P1 through the 1a-th node N1a and to the first parasitic inductance L1 through the 6a-th node N6a. The input terminal of the second amplification stage 120 may be connected to the first port P1 through the 3a-th node N3a and to the (2-2)-th switch SW2-2 through the 6a-th node N6a. The input terminal of the third amplification stage 130 may be connected to the second port P2 through the 2a-th node N2a and to the (1-2)-th switch SW1-2 through the 5a-th node N5a. The input terminal of the fourth amplification stage 140 may be connected to the second port P2 through the 4a-th node N4a and to the second parasitic inductance L2 through the 5a-th node N5a.

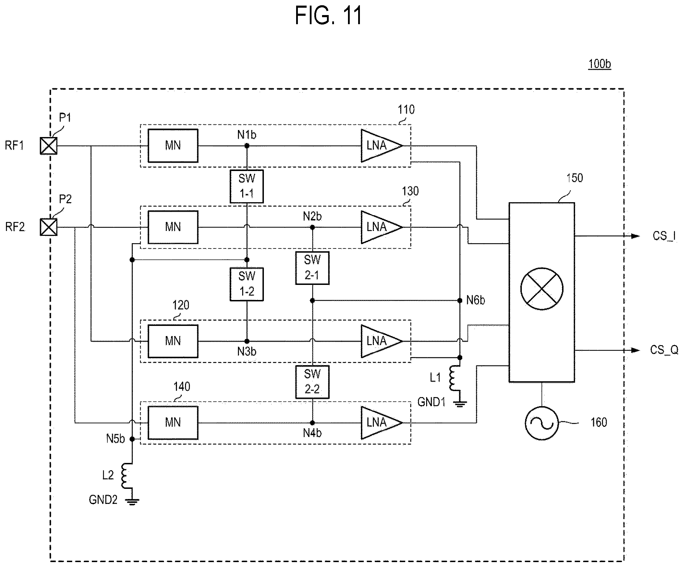

FIG. 11 illustrates an RF circuit according to some embodiments.

Referring to FIG. 11, according to some embodiments, when each of the plurality of amplification stages 110 to 140 includes a matching network MN and an LNA, the plurality of switches SW1-1 to SW2-2 described above may be provided between the matching network MN and the LNA included in each of the plurality of amplification stages 110 to 140. Accordingly, the first port P1 and the second port P2 may be directly connected to the matching network MN. In addition, the output terminal of the LNA may be directly connected to the mixer stage 150.

The switch SW1-1 may be connected to a 1b-th node N1b and a 5b-th node N5b between the matching network MN and the LNA of the first amplification stage 110. The (1-2)-th switch SW1-2 may be connected to the 5b-th node N5b connected to the second parasitic inductance L2 and a 3b-th node N3b between the LNA and the matching network MN of the second amplification stage 120. The (2-1)-th switch SW2-1 may be connected to a 2b-th node N2b between the matching network MN and the LNA of the third amplification stage 130 and a 6b-th node N6b connected to the first parasitic inductance L1. The (2-2)-th switch SW2-2 may be connected to the 6b-th node N6b and a 4b-th node N4b between the matching network MN and the LNA of the fourth amplification stage 140.

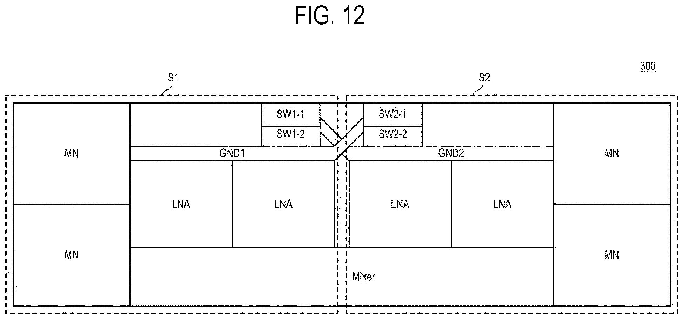

FIG. 12 illustrates the layout of an RF circuit according to some embodiments of the present disclosure.

Referring to FIG. 12, an RF circuit 300 according to some embodiments may include a plurality of matching stages MN, a plurality of LNA blocks LNA, and a mixer. The matching network may be included in the amplification stage according to the embodiments described above. The plurality of LNA blocks LNA may correspond to the LNA included in the amplification stage according to some embodiments described above. The mixer may correspond to the mixer stage according to some embodiments described above.

The first ground GND1 may be connected to at least one matching stage MN and/or at least one LNA block LNA, and the second ground GND2 may be connected to at least one matching stage MN and/or at least one LNA block LNA.

The (2-1)-th switch SW2-1 and the (2-2)-th switch SW2-2 may be connected to the first ground GND1, and the (1-1)-th switch SW1-1 and the (1-2)-th switch SW1-2 may be connected to the second ground GND2. In particular, when viewed in a layout, the first ground GND1 and the second ground GND2 may cross or overlap each other and be connected to each of the aforementioned switches.

When the RF circuit 300 is grouped into a first stage S1 and a second stage S2 as shown, the (1-1)-th switch SW1-1 and the (1-2)-th switch SW1-2 included in the first stage S1 may be connected to the second ground GND2 included in the second stage S2 rather than the first ground GND1 included in the first stage S1. In addition, the (2-1)-th switch SW2-1 and the (2-2)-th switch SW2-2 included in the second stage S2 may be connected to the first ground GND1 included in the first stage S1 rather than the second ground GND2 included in the second stage S2. In this case, for example, when the first stage S1 operates to receive a wanted signal, the (1-1)-th switch SW1-1 and the (1-2)-th switch SW1-2 may be turned off and the (2-1)-th switch SW2-1 and the (2-2)-th switch SW2-2 may be turned on. Accordingly, the aggressor signal reflected from the parasitic inductance of the first ground GND1 may be applied to the first stage S1.

Alternatively, for example, when the second stage S2 operates to receive a wanted signal, the (2-1)-th switch SW2-1 and the (2-2)-th switch SW2-2 may be turned off and the (1-1)-th switch SW1-1 and the (1-2)-th switch SW1-2 may be turned on. Accordingly, the aggressor signal reflected from the parasitic inductance of the second ground GND2 may be applied to the second stage S2.

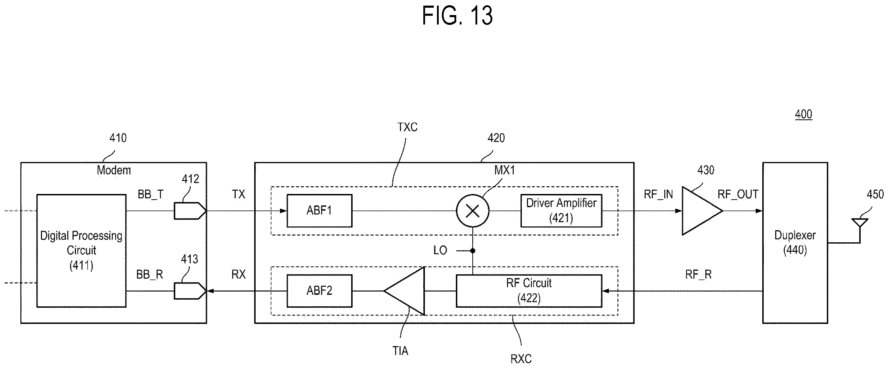

FIG. 13 illustrates a wireless communication device according to some embodiments of the present disclosure.

Referring to FIG. 13, a wireless communication device 400 may include a modem 410, an RF integrated-circuit (RFIC) 420, a power amplifier 430, a duplexer 440, and an antenna 450.

The modem 410 may include a digital processing circuit 411, an analog-to-digital converter (ADC) 413, and a digital-to-analog converter (DAC) 412.

The modem 410 may process a baseband signal BB_T (including, for example, I signals and Q signals) containing information to be transmitted through the digital processing circuit 411 according to various communication schemes. The modem 410 may process a received baseband signal BB_R through the digital processing circuit 411 according to various communication schemes.

For example, the modem 410 may process a signal to be transmitted or received according to a communication scheme such as orthogonal frequency division multiplexing (OFDM), orthogonal frequency division multiple access (OFDMA), wideband code multiple access (WCDMA), and high speed packet access+ (HSPA+). In addition, the modem 410 may process the baseband signal BB_T or BB_R according to various types of communication schemes (e.g., various communication schemes in which technology for modulating or demodulating the amplitude and frequency of the baseband signal BB_T or BB_R is applied).

The digital processing circuit 411 may perform various processing operations on a baseband signal in a digital domain. For example, the digital processing circuit 411 may perform an envelope extraction operation, a digital envelope signal generation operation, a crest factor reduction (CFR), a shaping function (SF), a digital pre-distortion (DPD), a delay correction operation, and the like. For example, the envelope extraction operation may extract the envelope of the baseband signal BB_T, and the digital envelope signal generation operation may generate a digital envelope signal based on the extracted envelope. The digital envelope signal may be used to determine the operating voltage of the power amplifier 430. The CFR may reduce a peak-to-average power ratio (PAPR) of a communication signal (e.g., the baseband signal BB_T). The SF may transform the digital envelope signal to improve the efficiency and linearity of the power amplifier 430. The DPD may linearize the distortion of the power amplifier 430 by compensating for it in the digital domain. In addition, the delay correction operation may correct the delay of the digital envelope signal or the baseband signal BB_T.

At least one ADC 413 and DAC 412 may be provided. The modem 410 may convert the baseband signal BB_T to analog by using the DAC 412 to generate a transmission signal TX. In addition, the modem 410 may receive a reception signal RX, which is an analog signal, from the RFIC 420. In addition, the modem 410 may digitally convert the reception signal RX through the ADC 413 provided therein and extract the baseband signal BB_R which is a digital signal. For example, the reception signal RX may be a differential signal including a positive signal and a negative signal.

The RFIC 420 may generate an RF input signal RF_IN by performing a frequency up-conversion on the transmission signal TX or generate the reception signal RX by performing a frequency down-conversion on an RF reception signal RF_R. For example, the RFIC 420 may include a transmission circuit TXC for frequency up-conversion, a reception circuit RXC for frequency down-conversion, and a local oscillator LO.

In this case, the transmission circuit TXC may include a first analog baseband filter ABF1, a first mixer MX1, and a driver amplifier 421. For example, the first analog baseband filter ABF1 may include a low pass filter.

The first analog baseband filter ABF 1 may filter the transmission signal TX received from the modem 410 and provide the filtered signal to the first mixer MX1. In addition, the first mixer MX1 may perform a frequency up-conversion to convert the frequency of the transmission signal TX from the baseband to the high frequency band through the frequency signal provided by the local oscillator LO. Through the frequency up-conversion, the transmission signal TX may be provided to the driver amplifier 421 as the RF input signal RF_IN, and the driver amplifier 421 may primarily amplify the power of the RF input signal RF_IN and provide it to the power amplifier 430.

The power amplifier 430 may be supplied with a DC voltage or a variable power supply voltage (e.g., a dynamically variable output voltage), and secondarily amplify the power of the RF input signal RF_IN based on the supplied power voltage to generate an RF output signal RF_OUT. In addition, the power amplifier 430 may provide the generated RF output signal RF_OUT to the duplexer 440.

The reception circuit RXC may include a second analog baseband filter ABF2, a trans impedance amplifier TIA, and an RF circuit 422. For example, the second analog baseband filter ABF2 may include a low pass filter.

The RF circuit 422 may be implemented according to some embodiments described above. For example, the RF circuit 422 may be implemented according to some embodiments shown in FIGS. 1, 5, 10, 11 and 12, or may operate according to some embodiments shown in FIGS. 2 to 4 and 6 to 8.

The RF circuit 422 may amplify the RF reception signal RF_R provided from the duplexer 440, and may perform a frequency down-conversion to convert the frequency of the reception signal RF_R from a high frequency band to a baseband with the frequency signal provided by the local oscillator LO. Through this frequency down-conversion, the RF reception signal RF_R may be provided to the second analog baseband filter ABF2 as the reception signal RX, and the second analog baseband filter ABF2 may filter the reception signal RX and provide it to the modem 410.

As described above, the RF circuit 422 according to some embodiments may include a plurality of ports for internally receiving first to N-th RF signals corresponding to the RF reception signal RF_R, a plurality of amplification stages connected to the plurality of ports and first to N-th grounds to amplify the first to N-th RF signals, a plurality of switches, each of which has one terminal connected to one of the plurality of amplification stages, and an opposite terminal connected to grounds, and a mixer stage connected to the plurality of amplification stages to mix one of first to N-th RF signals with a LO signal and offset remaining RF signals.

In particular, when mixing one RF signal, as some of the plurality of switches are turned on/off, RF components reflected from the grounds among the RF components associated with the remaining RF signals may be transmitted to the mixer stage. The mixer stage may mix only the wanted RF signal with the LO signal by offsetting the reflected RF components and the remaining RF components.

The TIA may be connected to the output terminal of the mixer stage provided in the RF circuit 422 and be configured to amplify the mixing signal output from the mixer stage. For example, the TIA may be connected to the output terminal of the first mixer and the output terminal of the second mixer in FIG. 1 and amplify the first mixing signal output from the first mixer and the second mixing signal output from the second mixer. Then, the analog baseband filter ABF2 may filter the mixing signal and output the filtered reception signal RX.

For reference, the wireless communication device 400 may transmit a transmission signal through a plurality of frequency bands by using carrier aggregation (CA) technology. In addition, to accomplish this, the wireless communication device 400 may include a plurality of power amplifiers 430 that power amplify a plurality of RF input signals RF_IN that correspond to a plurality of carrier waves, respectively. However, in the embodiment of the present disclosure, for convenience of explanation, the case where there is only one power amplifier 430 is described as an example.

The duplexer 440 may be connected to the antenna 450 to separate the transmission frequency and the reception frequency. For example, the duplexer 440 may separate the RF output signal RF_OUT provided from the power amplifier 430 by frequency band and provide it to the antenna 450. In addition, the duplexer 440 may provide an external signal received from the antenna 450 to the LNA included in the RF circuit 422 of the reception circuit RXC of the RFIC 420. For example, the duplexer 440 may include a front terminal module with integrated duplexer (FEMiD).

For reference, the wireless communication device 400 may be provided with a switch structure that may separate the transmission frequency and the reception frequency instead of the duplexer 440. In addition, the wireless communication device 400 may be provided with a structure including the duplexer 440 and a switch to separate the transmission frequency and the reception frequency. However, for convenience of explanation, in an embodiment of the present disclosure, the wireless communication device 400 which is provided with the duplexer 440 that may separate the transmission frequency and the reception frequency is described as an example.

The antenna 450 may transmit the RF output signal RF_OUT frequency-separated by the duplexer 440 to an outside or provide the RF reception signal RF_R received from the outside to the duplexer 440. For example, the antenna 450 may include an array antenna, but the embodiment is not limited thereto.

For reference, the modem 410, the RFIC 420, the power amplifier 430, and the duplexer 440 may be individually implemented as ICs, chips, or modules. In addition, the modem 410, the RFIC 420, the power amplifier 430, and the duplexer 440 may be mounted together on a printed circuit board (PCB). However, the present disclosure is not limited thereto, and in some embodiments, at least some of the modem 410, the RFIC 420, the power amplifier 430, and the duplexer 440 may be implemented as a single communication chip.

Furthermore, the wireless communication device 400 shown in FIG. 13 may be included in a wireless communication system using a cellular network such as 5G, LTE, or the like, and may be included in a wireless local area network (WLAN) system, or another wireless communication system. For reference, the configuration of the wireless communication device 400 shown in FIG. 13 is only an example, and is not limited thereto, and may be configured in various manners according to communication protocols or communication schemes.

According to the above-described embodiments, the wireless communication device of the present disclosure may offset an aggressor signal through the switches provided inside the RF circuit 422 included inside the RFIC. Accordingly, the wireless communication device may transmit only the wanted signal to the ADC 413. In addition, the wireless communication device may isolate aggressor signals without providing an additional switch outside the RFIC (e.g., the duplexer 440, and the like).

Example embodiments of the present disclosure have been described above. The present disclosure may include not only the above-described embodiments, but also various changes to the embodiments within the scope of the appended claims. Therefore, the scope of the present disclosure should not be limited to the above-described embodiments.

## Claims

1. A radio frequency, RF, circuit comprising:
a first port (P1) configured to receive a first RF signal (RF 1) and a second port (P2) configured to receive a second RF signal (RF2);
a (1-1)-th amplification stage (110; 210) and a (1-2)-th amplification stage (120; 220) connected to the first port (P1) and a first ground (GND1), wherein the (1-1)-th amplification stage (110; 210) and the (1-2)-th amplification stage (120; 220) are configured to amplify the first RF signal (RF1);
a (2-1)-th amplification stage (130; 230) and a (2-2)-th amplification stage (140; 240) connected to the second port (P2) and a second ground (GND2), wherein the (2-1)-th amplification stage (130; 230) and the (2-2)-th amplification stage (140; 240) are configured to amplify the second RF signal (RF2);
a (1-1)-th switch (SW1-1) having a first terminal connected to the (1-1)-th amplification stage (110; 210) and a second terminal connected to the second ground (GND2), and a (1-2)-th switch (SW1-2) having a first terminal connected to the (1-2)-th amplification stage (120; 220) and a second terminal connected to the second ground (GND2);
a (2-1)-th switch (SW2-1) having a first terminal connected to the (2-1)-th amplification stage (130; 230) and a second terminal connected to the first ground (GND1), and a (2-2)-th switch (SW2-2) having a first terminal connected to the (2-2)-th amplification stage (140; 240) and a second terminal connected to the first ground (GND1); and
a mixer stage (150; 270) connected to the (1-1)-th amplification stage (110; 210) and the (1-2)-th amplification stage (120; 220) and configured to mix the first RF signal (RF1) or the second RF signal (RF2) with a local oscillator, LO, signal, and connected to the (2-1)-th amplification stage (130; 230) and the (2-2)-th amplification stage (140; 240) and configured to mix the first RF signal (RF1) or the second RF signal (RF2) with the LO signal.

2. The RF circuit of claim 1, wherein the (1-1)-th switch (SW1-1) and the (1-2)-th switch (SW1-2) are turned off and the (2-1)-th switch (SW2-1) and the (2-2)-th switch (SW2-2) are turned on to mix the first RF signal (RF1), and
the (1-1)-th switch (SW1-1) and the (1-2)-th switch (SW1-2) are turned on and the (2-1)-th switch (SW2-1) and the (2-2)-th switch (SW2-2) are turned off to mix the second RF signal (RF2).

3. The RF circuit of claim 2, wherein a second RF component reflected from the first ground (GND1) among second RF components associated with the second RF signal (RF2) is transmitted to the mixer stage (150) when the (2-1)-th switch (SW2-1) and the (2-2)-th switch (SW2-2) are turned on.

4. The RF circuit of claim 3, wherein the mixer stage (150) is configured to offset the reflected second RF component and a remaining second RF component input through the (2-1)-th amplification stage (130; 230), and offset the reflected second RF component and a remaining second RF component input through the (2-2)-th amplification stage (140; 240).

5. The RF circuit of any one of claims 2 to 4, wherein a first RF component reflected from the second ground among first RF components associated with the first RF signal (RF1) is transmitted to the mixer stage (150; 270) when the (1-1)-th switch (SW1-1) and the (1-2)-th switch (SW1-2) are turned on

6. The RF circuit of claim 5, wherein the mixer stage (150; 270) is configured to offset the reflected first RF component and a remaining first RF component input through the (1-1)-th amplification stage (110; 210), and offset the reflected first RF component and a remaining first RF component input through the (1-2)-th amplification stage (120; 220).

7. The RF circuit of any one of claims 1 to 6, wherein each of the (1-1)-th amplification stage (110; 210), the (1-2)-th amplification stage (120; 220), the (2-1)-th amplification stage (130; 230), and the (2-2)-th amplification stage (140; 240) includes a matching network and a low noise amplifier, LNA, connected to the matching network.

8. The RF circuit of any one of claims 1 to 7, further comprising:
an oscillator configured to provide the LO signal to the mixer stage (150; 270).

9. The RF circuit of any one of claims 1 to 8, wherein the mixer stage (150; 270) is connected to a first node (N1; N7) corresponding to an output terminal of the (1-1)-th amplification stage (110; 210), a second node (N2; N9) corresponding to an output terminal of the (2-1)-th amplification stage (130; 230), a third node (N3; N8) corresponding to an output terminal of the (1-2)-th amplification stage (120; 220), and a fourth node (N4; N10) corresponding to an output terminal of the (2-2)-th amplification stage (140; 240).

10. The RF circuit of claim 9, wherein the (1-1)-th switch (SW1-1) is connected to the first node (N1; N7) and a fifth node (N5; N13) connected to the second ground (GND2), and the (1-2)-th switch (SW1-2) is connected to the third node (N3) and the fifth node (N5; N13).

11. The RF circuit of claim 10, wherein the (2-1)-th switch (SW2-1) is connected to the second node (N2; N9) and a sixth node (N6) connected to the first ground (GND1), and the (2-2)-th switch (SW2-2) is connected to the fourth node (N4; N10) and the sixth node (N6).

12. The RF circuit of any one of claims 1 to 11, further comprising:
a trans impedance amplifier (TIA) connected to an output terminal of the mixer stage (150; 270) to amplify a mixing signal output from the mixer stage (150; 270).

13. A communication device comprising:
an antenna (450) configured to transmit a radio frequency, RF, transmission signal or receive an RF reception signal;
a duplexer (440) configured to separate the RF transmission signal and the RF reception signal; and
the RF circuit (422) according to any one of the preceding claims, wherein the RF circuit is configured to mix one of a first RF signal (RF 1) to a N-th RF signal (RFN) included in the RF reception signal with a local oscillator, LO, signal and offset remaining RF signals of the first RF signal (RF1) to the N-th RF signal (RFN) that were not mixed,
wherein the RF circuit (422) includes:
a plurality of ports (P1-PN) configured to receive the first RF signal (RF1) to the N-th RF signal (RFN);
a plurality of amplification stages (210 to 260) connected to the plurality of ports (P1-PN) and a first ground GND1) to a N-th ground (GNDN) to amplify the first RF signal (RF1) to the N-th RF signal (RFN);
a plurality of switches (SW1-1 to SWN-1, SW1-2 to SWN-2), each having a first terminal connected to one of the plurality of amplification stages (210-260), and a second terminal connected to one of the first ground (GND1) to the N-th ground (GNDN); and
a mixer stage (270) connected to the plurality of amplification stages (210 to 260) to mix the one RF signal with the LO signal and offset the remaining RF signals.

14. The communication device of claim 13, wherein when at least one switch of the plurality of switches (SW1-1 to SWN-1, SW1-2 to SWN-2) is turned off, and remaining switches except for the at least one switch that is turned off are turned on when the one RF signal amplified through one of the plurality of amplification stages (210 to 260) is mixed.

15. The communication device of claim 13 or 14, further comprising:
a trans impedance amplifier (TIA) connected to an output terminal of the mixer stage (270) to amplify a mixing signal output from the mixer stage (270);
an analog baseband filter (ABF2) configured to filter the mixing signal and output a filtered reception signal; and
a modem (410) configured to process the reception signal.
